## Europäisches Patentamt
## European Patent Office
## Office européen des brevets

(19)

(11) Publication number: **0 222 943**
**B1**

(12) **EUROPEAN PATENT SPECIFICATION**

(45) Date of publication of the patent specification: 07.02.90

(51) Int. Cl.⁴: **H03M 7/42**

(21) Application number: 85308006.7

(22) Date of filing: 04.11.85

(54) Variable word length encoder.

(43) Date of publication of application: 27.05.87 Bulletin 87/22

(45) Publication of the grant of the patent: 07.02.90 Bulletin 90/6

(84) Designated Contracting States: AT DE FR GB NL SE

(56) References cited:
US-A- 4 396 906

IBM TECHNICAL DISCLOSURE BULLETIN, vol. 15, no. 12, May 1973, page 3707, New York, US; P.G. CARTA.: "Huffman encoder"

(73) Proprietor: NORTHERN TELECOM LIMITED, 600 de la Gauchetiere Street West, Montreal Quebec H3B 4N7(CA)

(72) Inventor: Bahgat, Osama Abu El-Kheir Hussein, 520 Landreville Apt. 1M Nun's Island, Verdun Quebec, H3E 1B4(CA)

(74) Representative: Crawford, Andrew Birkby et al, A.A. THORNTON & CO. Northumberland House 303-306 High Holborn, London WC1V 7LE(GB)

## Description

The invention relates to variable word length coders for digital signals and is especially, but not exclusively, applicable to predictive differential pulse code modulation systems for video or voice transmission and/or storage.

In such systems it is generally desirable to reduce the number of bits needed to be transmitted or stored while preserving the integrity of the reconstituted signal. In predictive systems this is achieved by transmitting a prediction error signal representing the difference between an instant signal element value and a predicted value oerived from a number of preceding signal elements. There is usually a strong correlation between neighbouring values of a video or voice signal so the predicted value will generally be very close to the instant value. Consequently it is more probable that the prediction error signal will be zero, or small, than large. Nevertheless, the system must be capable of handling large prediction error signals as and when they occur. Hence, if the prediction error signal is quantized, the outer levels of the quantizer are rarely used. In order to avoid such inefficient use of the system capacity, it has been proposed to apply the prediction error signal to a variable word length coder which has shorter words assigned to the inner levels around zero, where the probability of data generation is high. Thus, on average, efficient transmission is achieved. One known possibility is to apply the output of the coder, in parallel form, to a parallel to serial converter and thence to a serial buffer memory. A disadvantage of such an arrangement is that the buffer memory must have a capacity and writing rate sufficient to accommodate the longest variable word length coded word at the basic system frequency. For example, if a clock frequency is 8 MHZ and the longest word is 25 bits long, then the rate of writing the data into the buffer memory varies between 8 megabits per second and 200 megabits per second. Accordingly, hardware to handle such a speed is difficult zu realize. Moreover, difficulty arises in parallel to serial conversion when the size of the words at the input to the parallel to serial converter is inherently variable.

An object of the present invention is to eliminate or at least mitigate these disadvantages.

According to the present invention apparatus for variable word-length encoding of input signals comprising fixed length binary words, comprises:

(i) MEMORY MEANS responsive selectively to one of:
(a) an input signal comprising a first binary word and a first control signal or
(b) a delayed feedback signal comprising a second binary word and, alternatively, at least said first or a second control signal, for generating a feedback signal and an output signal comprising a binary bit;
(ii) DELAY MEANS of one bit period responsive to said memory means for generating said delay feedback signal;
(iii) SELECTION MEANS responsive to said first or second control signal to select said input signal or said delayed feedback signal, respectively and alternatively, for application to said memory means; and
(iv) MEANS FOR APPLYING said delayed feedback signal to said selection means,
the arrangement being such that
(a) when responding to a said input signal in which said first binary word has a magnitude greater than zero, said memory means causes said feedback signal to comprise said second control signal and second binary word corresponding in magnitude to the first binary word and said output bit to have a prescribed one of its two states;
(b) when responding to a said delayed feedback signal comprising a said second binary word having a magnitude greater than unity and said second control signal, said memory means causes said feedback signal next generated to comprise said second control signal and a said second binary word of magnitude one less than that applied to the memory means and said output signal to comprise a binary bit having the other of its two states;
(c) when responding to a said delayed feedback signal which comprises a said second binary word of magnitude equal to unity and said second control signal, the memory means generates a feedback signal comprising said first control signal and a said second binary word of magnitude zero, and an output signal comprising a bit having said prescribed one state;
such that for each input binary word of non-zero magnitude, said apparatus generates an output comprising a sequence of bits comprising a first bit in said prescribed one of two possible states followed by $(m-1)$ bits in said other of two possible states, followed by a final bit in said prescribed one of two possible states, where m is the magnitude of said input first binary word.

An exemplary embodiment of the invention will now be described with reference to the accompanying drawings in which

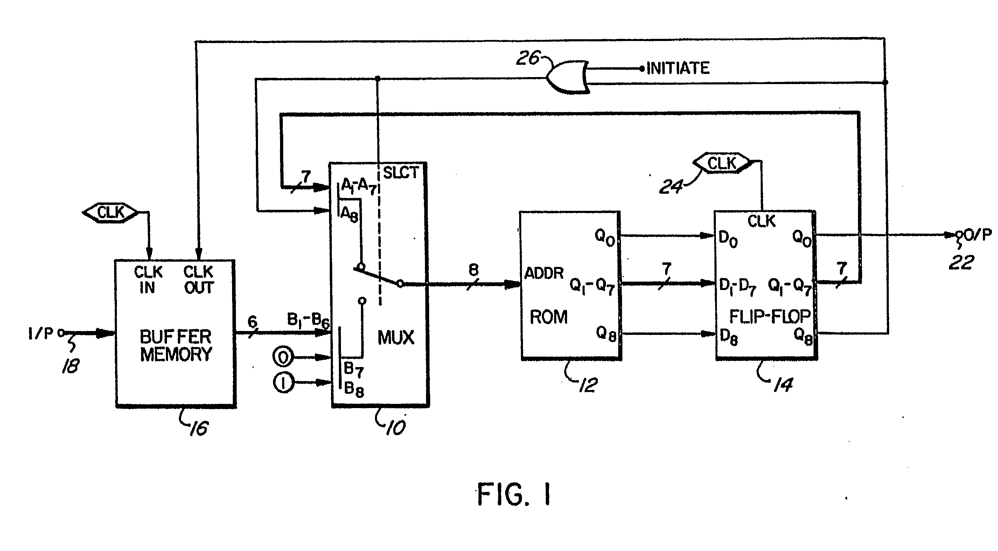

Figure 1 is a schematic representation of a variable word length encoder deriving its input from a parallel buffer memory.

An associated decoder is the subject of a copending application entitled "Variable Word Length Decoder" having application no. 85 308 005.9 and publication no. EP-A 0 222 942, and the same date as this application.

Referring to figure 1, an encoder for encoding binary words of fixed length into words of variable length comprises selection means in the form of a multiplexer (MUX) 10, having two input sets, denoted A and B, each of eight inputs; memory means in the form of a read-only memory (ROM) 12; and output delay means in the form of a flip-flop 14. Six bit parallel signed binary words are supplied to the encoder from input storage means in the form of a parallel buffer remory 16, which has an input bus 18 to receive such words from a suitable source (not shown).

A typical source is the quantizer output of a predictive encoder as used in an adaptive differential pulse code modulation system. Table 1 illustrates, for levels ranging from -13 to +13, the signed binary representation of such a quantizer output. Each such binary word has one bit denoting its polarity and five bits representing its magnitude. It will be appreciated that although only thirteen levels are shown in the table, the five bits will give a range of 31 levels, and even greater ranges can be achieved merely by increasing the number of bits.

The third column of table 1 shows a typical variable length word for each level. It will be noted that the zero level is unique in that its corresponding output word is a single '0' bit. All other variable output words have in common a start bit (1), a polarity bit (1 or 0), end bit (1) and an intervening series of zero bits, the number of which depends upon the numerical level. More specifically, the number of zero bits is one less than the level number. Thus, the variable length words representing level one have no zero magnitude bits (note that the zero in the plus one representation is a polarity bit) and the words representing level thirteen have twelve intervening zero bits. As mentioned in the introduction, the utility of the code is predicted upon the fact that the quantizer output remains close to zero because of the correlation between neighbouring elements of the voice or video signal being encoded. Therefore, on average the output word will be shorter than the corresponding six-bit input word.

Referring again to Figure 1, the binary words from the buffer memory 16 are applied by way of a six-line bus to inputs $B_1$ to $B_6$ of the multiplexer 10. The remaining two inputs of that set, $B_7$ and $B_8$, are maintained permanently at binary levels "0" and "1" respectively. This may be done by connecting inputs $B_7$ and $B_8$ to a low and a high voltage source, respectively. These two bits serve as a first control signal, as will be explained hereafter.

The corresponding eight-bit words output from the multiplexer 10 are applied to the address inputs of the ROM 12. Each produces a nine-bit output word at outputs $Q_0$–$Q_8$ respectively, of the ROM 12. Output $Q_0$ is coupled individually via the flip-flop 14 to the serial output terminal 22 of the encoder. ROM outputs $Q_1$ to $Q_7$ are applied by way of the flip-flop 14 to inputs $A_1$ to $A_7$ of the multiplexer 10. The most significant bit of the ROM output, $Q_8$, is coupled individually via the flip-flop 14 to the CLOCK-OUT input of the buffer memory 16, and to inputs $A_8$ and select (SLCT) of the multiplexer 10.

The flip-flop 14, which is controlled by a clock 24, serves to delay or store the ROM output during any one bit period for application to the output 22 and multiplexer 10 during the next bit period.

It will be appreciated, however, that the least significant bit from ROM output $Q_0$ might be applied, without delay, directly to the apparatus output 22.

Levels "1" and "0" at its SLCT input cause the multiplexer 10 to connect input sets "B" and "A", respectively, to the ROM address.

Operation of the apparatus may be initiated by means of an OR gate 26 interposed between the flip-flop 14 and the SLCT input of the multiplexer 10, whereby the multiplexer 10 can be made to select inputs B to receive a new binary word.

The apparatus has two basic modes of operation (i) and (ii) depending upon whether or not the binary word at the multiplexer's B inputs has a magnitude of zero.

Mode (i): As shown in Table 2, if the input word is (000000), after addition of the control signal (10), the corresponding ROM address will be (10000000). The corresponding ROM output is the same, with an additional zero as the least significant bit $Q_0$. Therefore, the variable word length representation appearing at the output terminal 22 will be a single (0). The feedback part of the ROM output, bits $Q_1$ to $Q_7$. will comprise a magnitude part (00000), a sign bit (0), a control bit (0), and the most significant bit, $Q_8$, will again be (1) as the multiplexer 10 will maintain selection of the B inputs for application to the R0M address and a new six-bit binary word will be clocked out of the buffer memory 16.

Mode (ii): If the new binary word has a non-zero magnitude, the apparatus operates cyclically for a series of bit periods, during which the variable length output word is generated serially by ROM output $Q_0$. In the first step of the series the ROM generates a (0) for the most significant bit $Q_8$, to select the A inputs for subsequent steps, and a (1) as the least significant bit $Q_0$, which is the first bit of the variable length output word.

Ignoring for the moment the second step, which is concerned only with detecting the polarity of the word to be encoded, it will be seen that in the third and, if any, subsequent steps, a second control signal, comprising a (0) as the most significant bit (generated by the ROM output in the preceding step) appears at the ROM address. So long as the associated magnitude is greater than unity, the corresponding ROM output will comprise the second control signal comprising a (0) in the most significant bit, a magnitude part having a numerical value of one less than that of the magnitude of the addressing word, and a (0) as the serial output $Q_0$. Accordingly, the apparatus "counts down" the binary input word and in the process generates a series of zeros in the variable length output word.

When the magnitude of the addressing word is unity, the corresponding ROM output comprises the first control signal comprising a (1) in the most significant bit again, a magnitude of zero, and a '1' as the serial output bit. This terminates the series of steps since the most significant bit $Q_8$ is (1), causing the multiplexer 10 to select inputs B again to input a new binary word from the buffer memory 16.

It will be appreciated that when the levels are plus or minus one, the magnitude of the input word is already zero. Accordingly, the third step is also the last and no string of zeros representing magnitude is generated. It will be noted that for level plus one there is a single zero in the variable length output word. However, this zero represents polarity. The polarity-representing bit always appears as the second bit of the variable length output word and is therefore generated in the second step.

As mentioned previously, in the first step of generating a non-zero word, the ROM output produces a (0) as the most significant bit, $Q_8$. In addition the ROM produces a (1) as the second most significant bit $Q_7$. Consequently, in the second step the ROM address comprises a second control signal comprising a (0) in the most significant bit and a third control signal comprising a (1) in the second most significant bit. The remainder of the address is the six-bit word, its sign and magnitude bits unchanged, as it was reproduced by the ROM output in the first step. The corresponding ROM output in the second step comprises, the second control signal comprising a (0) in the most significant bit, a (0) in the second most significant bit, the magnitude part of the address word, unchanged, and a serial output bit, $Q_0$, which is (1) or (0) depending upon the polarity of the word being encoded. It should be noted that the sign bit in the feedback signal can be with or without change because it is irrelevant after the completion of the second step. Thus the sign bit $Q_6$ will be (0) regardless of its value at the input.

It will be appreciated that, if the binary words to be encoded are all of the same polarity, the second step in the series can be omitted. It will also be appreciated that the polarity bit might be elsewhere in a non-unity output word, rather than the second bit. Moreover, rather than signify sign or polarity, the additional bit might characterize another feature of the word, for example, the additional bit might merely distinguish between words of similar probability of occurrence. Also, more than one additional bit might be used for these or other purposes.

| INPUT LEVEL | SIGNED BINARY REPRESENTATION | OUTPUT - VARIABLE WORD LENGTH REPRESENTATION | WORD LENGTH |
|---|---|---|---|
| -n | s i g MAGNITUDE n | s i g n | n+2 |
| -13 | 1 0 1 1 0 1 | 1 1 0 0 0 0 0 0 0 0 0 0 0 0 1 | 15 |
| -12 | 1 0 1 1 0 0 | 1 1 0 0 0 0 0 0 0 0 0 0 0 1 | 14 |
| -11 | 1 0 1 0 1 1 | 1 1 0 0 0 0 0 0 0 0 0 0 1 | 13 |
| -10 | 1 0 1 0 1 0 | 1 1 0 0 0 0 0 0 0 0 0 1 | 12 |
| -9 | 1 0 1 0 0 1 | 1 1 0 0 0 0 0 0 0 0 1 | 11 |
| -8 | 1 0 1 0 0 0 | 1 1 0 0 0 0 0 0 0 1 | 10 |
| -7 | 1 0 0 1 1 1 | 1 1 0 0 0 0 0 0 1 | 9 |
| -6 | 1 0 0 1 1 0 | 1 1 0 0 0 0 0 1 | 8 |
| -5 | 1 0 0 1 0 1 | 1 1 0 0 0 0 1 | 7 |
| -4 | 1 0 0 1 0 0 | 1 1 0 0 0 1 | 6 |
| -3 | 1 0 0 0 1 1 | 1 1 0 0 1 | 5 |
| -2 | 1 0 0 0 1 0 | 1 1 0 1 | 4 |
| -1 | 1 0 0 0 0 1 | 1 1 1 | 3 |
| 0 | 0 0 0 0 0 0 | 0 | 1 |
| 1 | 0 0 0 0 0 1 | 1 0 1 | 3 |
| 2 | 0 0 0 0 1 0 | 1 0 0 1 | 4 |
| 3 | 0 0 0 0 1 1 | 1 0 0 0 1 | 5 |
| 4 | 0 0 0 1 0 0 | 1 0 0 0 0 1 | 6 |
| 5 | 0 0 0 1 0 1 | 1 0 0 0 0 0 1 | 7 |
| 6 | 0 0 0 1 1 0 | 1 0 0 0 0 0 0 1 | 8 |
| 7 | 0 0 0 1 1 1 | 1 0 0 0 0 0 0 0 1 | 9 |
| 8 | 0 0 1 0 0 0 | 1 0 0 0 0 0 0 0 0 1 | 10 |
| 9 | 0 0 1 0 0 1 | 1 0 0 0 0 0 0 0 0 0 1 | 11 |
| 10 | 0 0 1 0 1 0 | 1 0 0 0 0 0 0 0 0 0 0 1 | 12 |
| 11 | 0 0 1 0 1 1 | 1 0 0 0 0 0 0 0 0 0 0 0 1 | 13 |
| 12 | 0 0 1 1 0 0 | 1 0 0 0 0 0 0 0 0 0 0 0 0 1 | 14 |
| 13 | 0 0 1 1 0 1 | 1 0 0 0 0 0 0 0 0 0 0 0 0 0 1 | 15 |
| n | | | n+2 |

TABLE I.: Signed Binary Representation and VWL Representation of the Quantizer Levels

Note: 6-bit wide signed binary input is shown in the table. However, the width of the signs binary input can assume any value up to infinity.

| INPUT LEVEL | STEP # | INPUT B (MAGNITUDE) $B_8 B_7 B_6 \cdots B_1$ | INPUT A (MAGNITUDE) $A_8 A_7 A_6 \cdots A_1$ | SELECT INPUT $Q_8$ (1=B, 0=A) | PROM address (MAGNITUDE) | PROM out & F.F. out FEEDBACK PART $Q_8 Q_7 Q_6 \cdots Q_1 Q_0$ |
|---|---|---|---|---|---|---|
| -8 | 1 | 1 0 1 0 1 0 0 0 | 1 X X X X X X X | B | 1 0 1 0 1 0 0 0 | 0 1 1 0 1 0 0 0 1 |
|    | 2 | 1 0 0 0 0 0 1 0 0 | 0 1 1 0 1 0 0 0 | A | 0 1 1 0 1 0 0 0 | 0 0 0 0 1 0 0 0 1 |
|    | 3 | 1 0 0 0 0 0 1 0 0 | 0 0 0 0 0 1 0 0 0 | A | 0 0 0 0 1 0 0 0 | 0 0 0 0 0 1 1 1 0 |
|    | 4 | 1 0 0 0 0 0 1 0 0 | 0 0 0 0 0 0 1 1 1 | A | 0 0 0 0 0 1 1 1 | 0 0 0 0 0 1 1 0 0 |
|    | 5 | 1 0 0 0 0 0 1 0 0 | 0 0 0 0 0 0 1 1 0 | A | 0 0 0 0 0 1 1 0 | 0 0 0 0 0 1 0 1 0 |
|    | 6 | 1 0 0 0 0 0 1 0 0 | 0 0 0 0 0 0 1 0 1 | A | 0 0 0 0 0 1 0 1 | 0 0 0 0 0 1 0 0 0 |
|    | 7 | 1 0 0 0 0 0 1 0 0 | 0 0 0 0 0 0 1 0 0 | A | 0 0 0 0 0 1 0 0 | 0 0 0 0 0 0 1 1 0 |
|    | 8 | 1 0 0 0 0 0 1 0 0 | 0 0 0 0 0 0 0 1 1 | A | 0 0 0 0 0 0 1 1 | 0 0 0 0 0 0 1 0 0 |
|    | 9 | 1 0 0 0 0 0 1 0 0 | 0 0 0 0 0 0 0 1 0 | A | 0 0 0 0 0 0 1 0 | 0 0 0 0 0 0 0 1 0 |
|    | 10 | 1 0 0 0 0 0 1 0 0 | 0 0 0 0 0 0 0 0 1 | A | 0 0 0 0 0 0 0 1 | 1 0 0 0 0 0 0 0 1 |
| +4 | 1 | 1 0 0 0 0 0 1 0 0 | 1 0 0 0 0 0 0 0 | B | 1 0 0 0 0 1 0 0 | 0 1 0 0 0 1 0 0 1 |
|    | 2 | 1 0 0 0 0 0 0 1 | 0 1 0 0 0 1 0 0 | A | 0 1 0 0 0 1 0 0 | 0 0 0 0 0 1 0 0 0 |
|    | 3 | 1 0 0 0 0 0 0 1 | 0 0 0 0 0 1 0 0 | A | 0 0 0 0 0 1 0 0 | 0 0 0 0 0 1 1 0 |
|    | 4 | 1 0 0 0 0 0 0 1 | 0 0 0 0 0 0 1 1 | A | 0 0 0 0 0 0 1 1 | 0 0 0 0 0 1 0 0 |
|    | 5 | 1 0 0 0 0 0 0 1 | 0 0 0 0 0 0 1 0 | A | 0 0 0 0 0 0 1 0 | 0 0 0 0 0 0 1 0 |
|    | 6 | 1 0 0 0 0 0 0 1 | 0 0 0 0 0 0 0 1 | A | 0 0 0 0 0 0 0 1 | 1 0 0 0 0 0 0 1 |
| +1 | 1 | 1 0 0 0 0 0 0 1 | 1 0 0 0 0 0 0 0 | B | 1 0 0 0 0 0 0 1 | 0 1 0 0 0 0 0 1 1 |
|    | 2 | 1 0 0 0 0 0 0 0 | 0 1 0 0 0 0 0 1 | A | 0 1 0 0 0 0 0 1 | 0 0 0 0 0 0 0 1 0 |
|    | 3 | 1 0 0 0 0 0 0 0 | 0 0 0 0 0 0 0 1 | A | 0 0 0 0 0 0 0 1 | 1 0 0 0 0 0 0 1 |
| 0 | 1 | 1 0 0 0 0 0 0 0 | 1 0 0 0 0 0 0 0 | B | 1 0 0 0 0 0 0 0 | 1 0 0 0 0 0 0 0 0 |
| 0 | 1 | 1 0 0 0 0 0 0 0 | 1 0 0 0 0 0 0 0 | B | 1 0 0 0 0 0 0 0 | 1 0 0 0 0 0 0 0 0 |
| -1 | 1 | 1 0 1 0 0 0 0 1 | 1 0 0 0 0 0 0 0 | B | 1 0 1 0 0 0 0 1 | 0 1 1 0 0 0 0 1 1 |
|    | 2 | 1 0 0 0 1 1 1 1 | 0 1 1 0 0 0 0 1 | A | 0 1 1 0 0 0 0 1 | 0 0 0 0 0 0 0 1 1 |
|    | 3 | 1 0 0 0 1 1 1 1 | 0 0 0 0 0 0 0 1 | A | 0 0 0 0 0 0 0 1 | 1 0 0 0 0 0 0 1 |

TABLE 2 – EXAMPLES TO ILLUSTRATE THE OPERATION OF THE VWL CODER

NOTE: These examples illustrate the operation of a VWL coder which operates for signed binary words of length 6 bits each. However, the VWL coder can operate for any size of signed binary input words.

X = irrelevant

**EP 0 222 943 B1**

**Claims**

1. Apparatus for variable-word-length encoding of input signals comprising fixed length binary words, comprising:

(i) MEMORY MEANS responsive selectively to one of:

(a) an input signal comprising a first binary word and a first control signal or

(b) a delayed feedback signal comprising a second binary word and, alternatively, at least said first or a second control signal, for generating a feedback signal and an output signal comprising a binary bit;

(ii) DELAY MEANS of one bit period responsive to said memory means for generating said delayed feedback signal;

(iii) SELECTION MEANS responsive to said first or second control signal to select said input signal or said delayed feedback signal, respectively and alternatively, for application to said memory means; and

(iv) MEANS FOR APPLYING said delayed feedback signal to said selection means, the arrangement being such that

(a) when responding to a said input signal in which said first binary word has a magnitude greater than zero, said memory means causes said feedback signal to comprise said second control signal and second binary word corresponding in magnitude to the first binary word and said output bit to have a prescribed one of its two states;

(b) when responding to a said delayed feedback signal comprising a said second binary word having a magnitude greater than unity and said second control signal, said memory means causes said feedback signal next generated to comprise said second control signal and a said second binary word of magnitude one less than that applied to the memory means and said output signal to comprise a binary bit having the other of its two states;

(c) when responding to a said delayed feedback signal which comprises a said second binary word of magnitude equal to unity and said second control signal, the memory means generates a feedback signal comprising said first control signal and a said second binary word of magnitude zero, and an output signal comprising a bit having said prescribed one state;

such that for each input binary word of nonzero magnitude, said apparatus generates an output comprising a sequence of bits comprising a first bit in said prescribed one of two possible states followed by (m–1) bits in said other of two possible states, followed by a final bit in said prescribed one of two possible states, where m is the magnitude of said input first binary word.

2. Apparatus as defined in claim 1 wherein said memory means is responsive to said input signal comprising said first control signal and a said first binary word greater than zero to generate a said feedback signal additionally comprising a third control signal, and is subsequently responsive to the delayed feedback signal generated therefrom, additionally comprising said third control signal, to generate a feedback signal comprising said second control signal and a said second binary word having the same magnitude as the first binary word, and the output signal comprising a bit having a state dependent upon a predetermined characteristic of the first binary word in said input signal.

3. Apparatus as defined in claim 2, wherein said predetermined characteristic of said first binary word in said input signal is that it comprises a polarity bit and said memory means is responsive to said polarity bit in generating said output signal.

4. Apparatus as defined in claim 2 or 3, wherein said memory means is further responsive selectively to:

a said input signal comprising a first binary word of magnitude zero and said first control signal to generate a said feedback signal comprising a said second binary word of magnitude zero and said first control signal, and a said output signal comprising a bit representing zero.

**Patentansprüche**

1. Vorrichtung zur variablen Wortlängen-Kodierung von eingehenden Signalen, welche Binärworte festgelegter Länge umfassen, mit:

(i) SPEICHERMITTELN, die selektiv von einem der folgenden abhängig sind:

(a) einem Eingangssignal aus einem ersten Binärwort und einem ersten Steuersignal oder

(b) einem verzögerten Rückkoppelsignal, das ein zweites Binärwort und alternativ mindestens das erste und ein zweites Steuersignal umfaßt, zur Erzeugung eines Rückkoppelsignals und eines Ausgangssignals, welches ein binäres Bit umfaßt;

(ii) VERZÖGERUNGSMITTELN von einer Bitlänge, die auf die Speichermittel zur Erzeugung des verzögerten Rückkoppelsignals reagieren,

(iii) WAHLMITTELN, die auf das erste oder das zweite Steuersignal reagieren zum Anwählen des Eingangssignals oder des verzögerten Rückkoppelsignals, jeweilig und alternativ zum Anlegen an das Speichermittel; und

(iv) MITTELN ZUM ANLEGEN des verzögerten Rückkoppelsignals an die Wahlmittel, wobei die Anordnung so ist, daß

(a) bei Reaktion auf ein besagtes Eingangssignal, in welchem das erste Binärwort eine Größe größer Null besitzt, das Speichermittel das Rückkoppelsignal, das zweite Steuersignal und zweites Binärwort umfassen läßt, in Größe dem ersten Binärwort entsprechend, und das Ausgangsbit einen vorgeschriebenen von seinen zwei Zuständen haben läßt;

(b) bei Reaktion auf das verzögerte Rückkoppelsignal, welches besagtes zweites Binärwort mit einer Größe größer als Eins und das zweite Steuersignal umfaßt, das Speichermittel das als nächstes erzeugte Rückkoppelsignal, das zweite Steuersignal und das zweite Binärwort mit einer um eins kleineren Größe als das an das Speichermittel angelegte umfassen läßt und das Ausgangssignal ein Binärbit mit dem anderen seiner zwei Zustände umfassen läßt;

(c) bei Reaktion auf das verzögerte Rückkoppelsignal, welches ein besagtes zweites Binärwort mit einer Größe gleich Eins und das zweite Steuersignal umfaßt, das Speichermittel ein Rückkoppelsignal erzeugt, welches das erste Steuersignal und ein besagtes zweites Binärwort der Größe Null erzeugt, und ein Ausgangssignal, welches ein Bit mit dem vorgeschriebenen einen Zustand umfaßt;

so daß bei jedem Eingangsbinärwort mit Größe nicht Null die Vorrichtung ein Ausgangssignal erzeugt, das eine Bitfolge umfaßt, welche ein erstes Bit in dem vorgeschriebenen einen von zwei möglichen Zuständen umfaßt, gefolgt durch (m−1) Bit in dem besagten anderen von zwei möglichen Zuständen, gefolgt durch ein finales Bit in dem vorgeschriebenen einen von zwei möglichen Zuständen, wobei m die Größe des ersten eingehenden Binärwortes ist.

2. Vorrichtung nach Anspruch 1, bei der das Speichermittel auf das Eingangssignal reagiert, welches das erste Steuersignal und das erste Binärwort größer als Null umfaßt, um ein besagtes Rückkoppelsignal zu erzeugen, das zusätzlich ein drittes Steuersignal umfaßt, und nachfolgend auf das dadurch erzeugte verzögerte Rückkopplungssignal reagiert, das zusätzlich das dritte Steuersignal umfaßt, um ein Rückkoppelsignal zu erzeugen, welches das zweite Steuersignal und ein besagtes zweites Binärwort mit der gleichen Größe wie das erste Binärwort umfaßt, und das Ausgangssignal, welches ein Bit umfaßt mit einem von einer vorbestimmten Charakteristik des ersten Binärwortes in dem Eingangssignal abhängigen Zustand.

3. Vorrichtung nach Anspruch 2, bei der die vorbestimmte Charakteristik des ersten Binärwortes in dem Eingangssignal ist, daß es ein Polaritätsbit umfaßt, und das Speichermittel auf das Polaritätsbit bei der Erzeugung des Ausgangssignal reagiert.

4. Vorrichtung nach Anspruch 2 oder 3, bei der das Speichermittel weiter selektiv reagiert auf:

ein besagtes Eingangssignal, welches ein erstes Binärwort von Größe Null und das erste Steuersignal umfaßt zur Erzeugung eines besagten Rückkopplungssignales, welches ein besagtes zweites Binärwort der Größe Null und das erste Steuersignal umfaßt und ein besagtes Ausgangssignal, welches ein Null darstellendes Bit umfaßt.

**Revendications**

1. Dispositif pour le codage à longueur de mots variable de signaux d'entrée comprenant des mots binaires de longueur fixe, comportant:

(i) un MOYEN DE MEMOIRE répondant sélectivement à l'un de:

(a) un signal d'entrée comprenant un premier mot binaire et un premier signal de commande ou

(b) un signal de réaction retardé comportant un second mot binaire et, alternativement, au moins ledit premier signal de commande ou un second signal de commande, pour produire un signal de réaction et un signal de sortie comportant un bit binaire;

(ii) un MOYEN A RETARD d'une période d'un bit répondant au moyen de mémoire pour générer le signal de réaction retardé;

(iii) un MOYEN DE SELECTION répondant au premier ou au second signal de commande pour sélectionner le signal d'entrée ou le signal de réaction retardé, respectivement et alternativement, pour application au moyen de mémoire; et

(iv) un MOYEN POUR APPLIQUER le signal de réaction retardé au moyen de sélection, l'agencement étant tel que

(a) lors de la réponse à un dit signal d'entrée dans lequel le premier mot binaire a une amplitude supérieure à zéro, le moyen de mémoire fait que le signal de réaction comprenne le second signal de commande et le second mot binaire correspondant en amplitude au premier mot binaire et que le bit de sortie ait un état prescrit parmi ses deux états;

(b) lors de la réponse à un dit signal de réaction retardé comprenant un dit second mot binaire ayant une amplitude supérieure à l'unité et ledit second signal de commande, le moyen de mémoire fait que le signal de réaction généré ensuite comprenne le second signal de commande et un dit second mot binaire d'amplitude inférieure à celle appliquée au moyen de mémoire et que le signal de sortie comprenne un bit binaire ayant l'autre de ses deux états;

(c) lors de la réponse à un dit signal de réaction retardé qui comprend un dit second mot binaire d'amplitude égale à l'unité et un dit second signal de commande, le moyen de mémoire produit un signal de réaction comprenant le premier signal de commande et un dit second mot binaire d'amplitude zéro, et un signal de sortie comprenant un bit ayant le premier état prescrit;

de sorte que, pour chaque mot binaire d'entrée d'amplitude non nulle, le dispositif produit une sortie comprenant une séquence de bits comportant un premier bit dans le premier état prescrit des deux états possibles suivi par (m−1) bits dans l'autre de deux états possibles, suivi par un bit final dans le premier état prescrit de deux états possibles, où m est l'amplitude du premier mot binaire d'entrée.

2. Dispositif selon la revendication 1, dans lequel le moyen de mémoire répond au signal d'entrée comprenant le premier signal de commande et un dit premier mot binaire supérieur à zéro pour produire un dit signal de réaction comprenant en plus un troisième signal de commande, et répond ensuite au signal de réaction retardé produit par celui-ci, comportant en plus le troisième signal de commande, pour produire un signal de réaction comprenant le second signal de commande et un dit second mot binaire ayant la même amplitude que le premier mot binaire, et le signal de sortie comportant un bit ayant un état dépendant d'une caractéristique prédéterminée du premier mot binaire dans le signal d'entrée.

3. Dispositif selon la revendication 2, dans lequel la caractéristique prédéterminée du premier mot binaire dans le signal d'entrée est qu'il comprend un bit de polarité et le moyen de mémoire répond au bit de polarité en produisant le signal de sortie.

4. Dispositif selon la revendication 2 ou 3, dans lequel le moyen de mémoire répond en outre sélectivement à un dit signal d'entrée comportant un premier mot binaire d'amplitude zéro et le premier signal de commande pour produire un dit signal de réaction comportant un dit second mot binaire d'amplitude zéro et le signal de commande, et un dit signal de sortie comportant un bit représentant zéro.

FIG. 1